Europäisches Patentamt

European Patent Office

Office européen des brevets

(19)

(11) Publication number: **0 037 259**

**A1**

(12) # EUROPEAN PATENT APPLICATION

(21) Application number: **81301312.5**

(22) Date of filing: **26.03.81**

(51) Int. Cl.³: **H 04 B 12/02**
**H 03 K 13/02**

(30) Priority: **27.03.80 JP 39214/80**

(43) Date of publication of application:
**07.10.81 Bulletin 81/40**

(84) Designated Contracting States:
**DE FR GB NL**

(71) Applicant: **VICTOR COMPANY OF JAPAN, LIMITED**
**3-12, Moriya-cho**
**Kanagawa-ku Yokohama(JP)**

(72) Inventor: **Toyomaki, Kazuya**
**c/o Victor Company of Japan Ltd. 3-12 Moriya-cho**
**Kanagawa-ku Yokohama(JP)**

(74) Representative: **Senior, Alan Murray et al,**
**J.A. KEMP & CO 14 South Square Gray's Inn**
**London WC1R 5EU(GB)**

(54) Circuit arrangement and method for reducing quantization distortion in a signal processing device.

(57) In a device having an analog-to-digital converter, which converts an input analog signal into a digital signal at a given conversion frequency, an auxiliary signal generator (30) for generating an auxiliary signal having a frequency, which equals one-half the conversion frequency, and an adder (26) for superimposing the auxiliary signal on the input analog signal, are employed. Thus the added or superposed signal is converted into a digital signal with small quantization distortion, effectively preventing S/N from being deteriorated. If desired, a dither signal may be added to the input analog signal before the auxiliary signal is added to the analog signal, so that quantization distortion will be further reduced.

./...

## FIG. 3

## TITLE

CIRCUIT ARRANGEMENT AND METHOD FOR REDUCING QUANTIZATION
DISTORTION IN A SIGNAL PROCESSING DEVICE

### FIELD OF THE INVENTION

This invention generally relates to a signal processing device having an analog-to-digital converter therein, and more particularly the present invention relates to a circuit arrangement and a method for reducig quantization distortion which is inherent to analog-to-digital conversion effected by sampling an input analog signal by a given sampling signal.

### BACKGROUND OF THE INVENTION

It is well known that so called quntization distortion (quantization noise) occurs theoretically when an analog signal, which may assume continuous values, is converted into a digital signal which exhibits a finite number of discrete or dispersed values. In some conventional circuit arrangement for converting an analog signal into a digital signal, no means for reducing quantization distortion is provided, and therefore, the quantization distortion resulted in harmful distortion in its output signal. In some other conventional devices, a circuit arrangement for reducing quantization distortion is provided. However, the conventional circuit arrangements have been suffered from various problems, such as deterioration of signal-to-noise (S/N) ratio or necessity of complex circuit arrangement as will be described hereinlater in detail.

## SUMMARY OF THE INVENTION

The present invention has been developed in order to remove the above-mentioned disadvantages and drawbacks inherent to the conventional signal processing device having an analog-to-digital convertor.

It is, therefore, an object of the present invention to provide a new and useful circuit arrangement and a method for reducing quantization distortion in a signal processing device having an analog-to-digital converter, so that deterioration of S/N is effectively prevented, while quantization distortion can be satisfactorily reduced.

According to a feature of the present invention, the signal processing device having an analog-to-digital converter is simple in construction resulting in a less manufacturing cost and a small size.

According to another feature of the present invention, the linearity of the analog-to-digital conversion may be improved.

In accordance with the present invention there is provided a circuit arrangement for reducing quantization distortion in a signal processing device having a portion in which an input analog signal is converted into digital data at a given conversion frequency, said circuit arrangement comprising:

(a) a first means for generating an auxiliary signal having a frequency which equals one-half said conversion frequency; and

(b) a second means for superposing said auxiliary signal on said input analog signal prior to converting said input analog signal into digital data.

In accordance with the present invention there is also provided a method for reducing quantization distortion in a signal processing device having a portion in which an input analog signal is converted into digital data, at a given conversion frequency, said method comprising the steps of:

(a) generating an auxiliary signal having frequency which equals one-half said conversion frequency; and

(b) superposing said auxiliary signal on said input analog signal prior to converting said input analog signal into digital data.

BRIEF DESCRIPTION OF THE DRAWINGS

The object and features of the present invention will become more readily apparent from the following detailed description of the preferred embodiments taken in conjunction with the accompanying drawings in which:

Fig. 1 is a block diagram of a conventional signal processing device which is not equipped with means for reducing quantization distortion;

Fig. 2 is a block diagram of the main part of another conventional signal processing device, which is equipped with means for reducing quaitization distortion;

Fig. 3 is a schematic block diagram of a first embodiment of the circuit arrangement according to the present invention;

Figs. 4A to 4D are waveform charts useful for understanding the operation of the circuit arrangement of Fig. 3;

Figs. 5A to 5D are waveform charts useful for understanding the operation of the circuit arrangement of Fig. 3 in comparison with the conventional device in which no countermeasure against quantization distortion is taken; and

Fig. 6 is a schematic block diagram of a second embodiment of the circuit arrangement according to the present invention.

## DETAILED DESCRIPTION OF THE PREFERRED EMBODIMENTS

Prior to describing the embodiments of the present invention, several conventional arrangements will be described for a better understanidng of the object and features of the present invention.

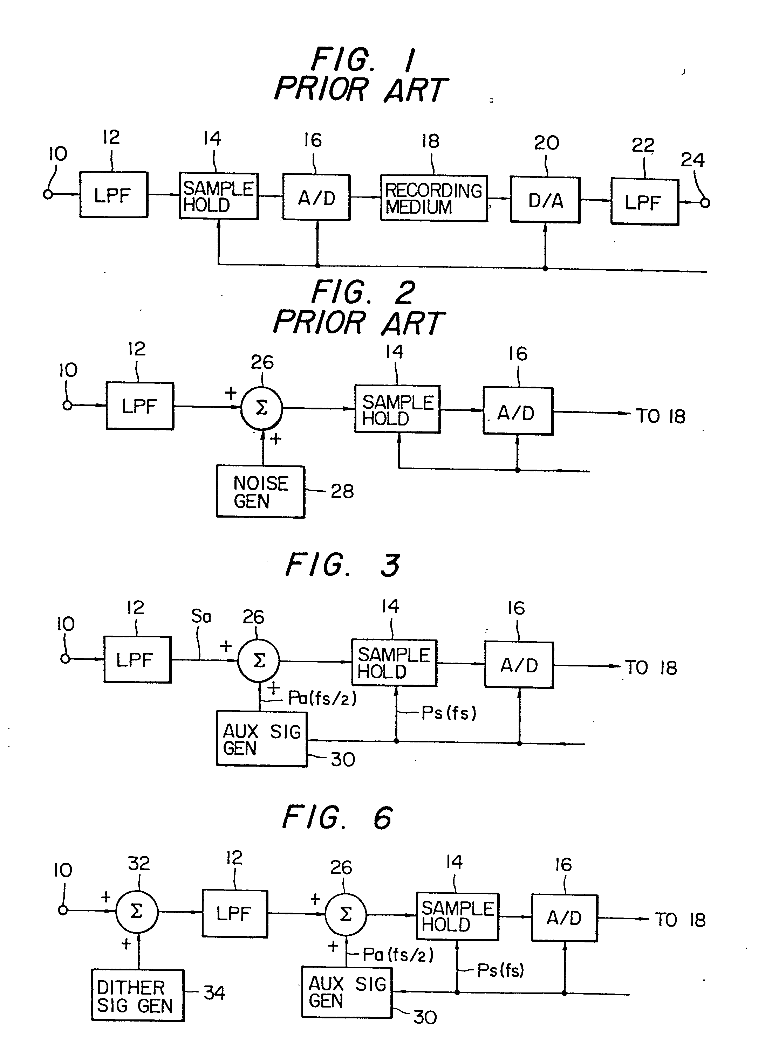

Fig. 1 is a block diagram of an example of a conventional signal processing device including an analog-to-digital converter, and in Fig. 1, a reference numeral 10 is an input terminal of an analog signal; 12 and 22, low pass filters (LPFs); 14, a sample-and-hold circuit; 16, an analog-to-digital (A/D) converter; 18, a transmission line or a recording medium; 20, a digital-to-analog (D/A) converter; and 24, an output terminal for an analog signal, so that the original analog signal applied to the input terminal 10 is fed via the low pass filter 12 to the sample-and-hold circuit 14 to be sampled, and then it will be converted into a digital signal which corresponds to the sampled values in the A/D converter 16. The digital signal emitted from the A/D converter 16 is fed via the transmission line or recording medium 18 to the D/A converter 20 to be converted into an analog signal, and then it will be emitted via the low pass filter 22 to the output terminal 24 as an analog signal. In Fig. 1, the sample-and-hold circuit 14, the A/D converter 16, the D/A converter 20 and the like are all supplied with a given timing control signal.

In the above-mentioned signal processing circuit of Fig. 1, since there is no means for reducing quantizing distortion which necessarily occurs in the A/D converter 16 especially when the input analog signal is of low level, the quantization noise becomes distortion which has a relationship with the input signal, and therefore, when the frquency is low, such as in the case of vocal sounds, a problem would arise because harmful distortion uncomfortable for ears occurs.

In order to resolve the above-mentioned drawbacks. in the signal processing circuit having an A/D converter, a technique of superposing a white noise (wideband noise signal) on the input analog signal has been taken hitherto. When such a countermeasure is taken, although the above-mentioned distortion can be reduced, there has been a problem that S/N was deterorated because noise in the signal increased.

In order to resolve the above-mentioned problem, there has been proposed a technique that a noise signal, which resides in a range between the input analog signal frequency range and the side band of the sampling signal, is superposed on the input analog signal as shown in Fig. 2. The arrangement of Fig. 2 differs from that of Fig. 1, in that an adder 26 is interposed between the low pass filter 12 and the sample-and-hold circuit 14, while the adder 26 is arranged to receive the above-mentioned noise signal from a noise signal generator 28. Fig. 2 only shows a main part of the signal processing device, and the same elements as in Fig. 1 are designated at like numerals.

In the already known apparatus of Fig. 2, the sample-and-hold circuit 14 is supplied with the output signal of the adder 26, i.e. the input analog signal on which the noise signal generated by the noise siganl generator 28 has been superposed, and if the noise signal generated by the noise siganl generator 28 is arranged such that its range is between the input analog signal frequency range and the side band of the sampling signal, it is possible to reduce the distortion under the condition that deterioration of S/N is relatively samll.

However, according to the conventional technique of Fig. 2, it is necessary to produce the noise signal, which occupies an extremely narrow band between the input analog signal range and the side band of the sampling signal, as the signal to be superimposed on the input analog signal. Such a noise signal can be hardly produced. Furthermore, it has a drawback that deterioration of S/N is inevitable because the noise signal necessarily falls in the band of the analog signal, while it leads to high cost because the device becomes complex, for instance, an AGC circuit is required for generating a constant level noise signal.

Reference is now made to Fig. 3, which shows a schematic block diagram of a main part of a first embodiment of the signal processing device according to the present invention. In Fig. 3, a reference numeral 10 is an input terminal of an analog signal; 26, an adder; 14, a sample-and-hold circuit; 16, an A/D converter; and 30, an auxiliary signal generator. Fig. 3 shows only a main part of the signal processing device, and therefore, the output terminal of the A/D converter 16 may be connected to a suitable circuit, such as the recording medium 18 or a transmission line of Fig. 1. The sample-and-hold circuit 14 and the A/D converter 16 are supplied with a given timing control signal in the same manner as in the conventional devices, and the timing control signal is also fed to the auxiliary signal generator 30.

In the sample-and-hold circuit 14, an analog signal applied thereto is sampled by a sampling signal Ps whose frequency is $f_s$, and the sampled values are held until next sampling to deliver an output signal to the A/D converter 16.

The A/D converter 16 converts the amplitude values (the sampled values obtained by the sampe-and-hold circuit 14) into corresponding digital signals to emit them. It is a matter of course that the conversion time of the A/D converter 16 is shorter than the sampling period $1/f_s$ in the sample-and-hold circuit 14, and digital signal outputs, which have been coded at the sampling period $1/f_s$, will be emitted from the A/D converter 16.

The auxiliary signal generator 30 is used for generating an auxiliary signal Pa having a frequency which equals one-half the frequency $f_s$ of the sampling signal Ps. The auxiliary signal Pa to be generated by the auxiliary signal generator 30 may assume any waveforms if its frequency is one-half the frequency of the sampling frequency $f_s$. In the case, that the auxiliary signal Pa is of a square wave, the auxiliary signal generator 30 may be constructed of a divide-by-two frequency divider. Since the auxiliary signal generator 30 may be constructed of such a simple frequency divider, it is advantageous that the entire device can be readily manufactured, while its manufacturing cost is low, and the device is samll in size.

Furthermore, when such a square wave signal is used as the auxiliary signal Pa, the adjustment of the phasic relationship between the auxiliary signal Pa and the sampling signal Ps can be readily effected so that the difference between adjacent sampled values resulted from continuous sampling equals the peak value of the auxiliary signal Pa, because the amplitude of such a square wave signal is constant for a given period of time.

Although the amplitude of the auxiliary signal Pa may be freely determined, if the auxiliary signal Pa is produced in such a manner that the difference between adjacent sampled values resulted from adjacent samplings is expressed in terms of $\frac{2n+1}{2}$ QS, wherein n=0, 1, 2, 3 .:. , and QS is a quantum step (unit amplitude of quantization steps), the quantization distortion reduction effect by means of the auxiliary signal Pa becomes the most remarkable.

An analog signal to be converted into a digital signal is applied via the input terminal 10 to a first input terminal of the adder 26, while the above-mentioned auxiliary signal Pa is applied to a second input terminal of the adder 26. The analog signal from the low pass filter is designated at a reference Sa. With this arrangemet, the auxiliary signal Pa is superposed on the analog signal Sa in the adder 26, and then the added or superposed signal is fed to the sample-and-hold circuit 14 to be sampled by the sampling signal Ps having the above-mentioned given frequency $f_s$. The sampled data will be fed to the A/D converter 16 in the same manner as in the conventional devices.

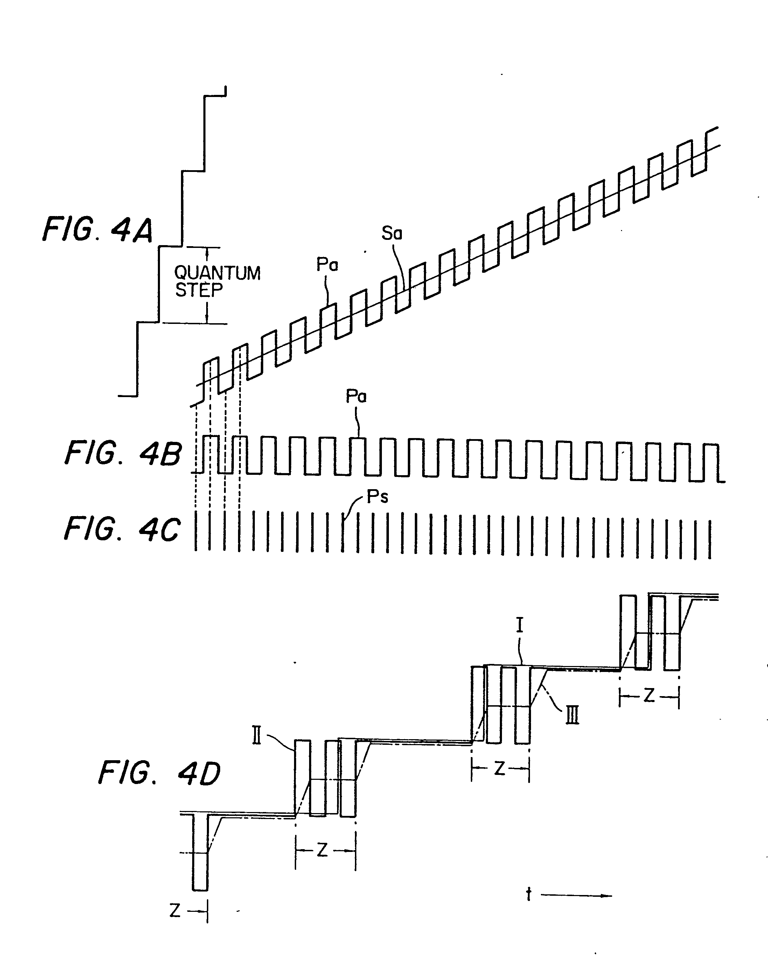

Now, the way of reducing quantization distortion will be described in detail with reference to Figs. 4A to 4D hereinbelow.

First, Fig. 4C shows the sampling timing by the sampling signal Ps, and Fig. 4B is a waveform chart of the auxiliary signal Pa in the case that a square wave is used as the auxiliary signal Pa. Fig. 4A shows the condition that the auxiliary signal Pa is superposed on the analog signal Sa by adding the auxiliary signal Pa illustrated in Fig. 4B to the analog signal Sa emitted from the low pass filter 12. The signal shown in Fig. 4A is sampled sequentially at the sampling timing of the sampling signal Ps in the sample-and-hold circuit 14, and the sampled values are held for a single sampling period to be converted into a digital signal in the A/D converter 16. The steps at the left side of Fig. 4A shows the quantization characteristic in the A/D converter 16, and the height of one step thereof corresponds to the above-mentioned quantum step (unit amplitude) QS.

Fig. 4D is a chart for explaining that the quantization distortion is more reduced in the case that the signal obtained by superposing the auxiliary signal Pa on the analog signal Sa is applied via the sample-and-hold circuit 14 to the A/D converter 16 compared to the case that only the analog signal Sa of

Fig. 4A is simply applied to the sample-and-hold circuit 14.
A light curve I and a heavy curve II respectively show
the condition that the output signal from the A/D
converter 16 is restored to an analog signal by the D/A
converter 20 shown in Fig. 1. Namely, the curve I
indicates the output signal from the D/A converter 20
in the case that only the analog signal Sa is applied to
the A/D converter 16, while the curve II indicates the
waveform of the output signal from the D/A converter 20
in the case that the signal obtained by superposing III in
the auxiliary signal Pa on the analog signal Sa is
applied to the A/D converter 16. A dot-dash line
Fig. 4D indicates the waveform of the output signal
of the low pass filter 22 of Fig. 1, which output signal
is obtained when the signal reprsented by the heavy
curve II is applied from the D/A converter 20 thereto.

As is apparent from the curve II of Fig. 4D,
since the auxiliary signal Pa having a frequency $f_s/2$,
which equals one-half the frequency $f_s$ of the sampling
signal Ps, is superposed on the analog signal Sa in
the present invention, there occurs a region Z in which
values of adjacent quantization steps appear alternatively
in the output signal of the D/A converter 20. The
output signal from the D/A converter 20 shows the
substantial quantization characterisitc in the A/D converter 16 in the case that the auxiliary signal Pa is syperposed on the analog signal Sa. Since the signal level variation in the range Z of the output signal from the D/A converter 20, as shown by the curve II, is caused by the auxiliary signal Pa, the frequency of the above-mentioned signal level variation equals the frequency $f_s/2$ of the auxiliary signal Pa.

On the other hand, the cutoff frequency $f_c$ of the low pass filter 22, which filters the output signal of the D/A converter 20, is selected as $f_c < f_s/2$, so that the level variation, which has occured in the region Z of the output signal of the D/A converter 20, does not pass through the low pass filter 22. Accordingly, an average value will be emitted because it is integrated by the interpolation effect of the low pass filter 22.

The way of level variation in the region Z of the output signal from the above-mentioned D/A converter 20 is such that the level assumes two values of the quantization steps during a single sampling period $(1/f_s)$, and therefore, the signal in the region Z is emitted as an average value after integrated by the low pass filter 22. This means that the way of the above-mentioned processing is equivalent to the condition that the signal in the region Z has been quantized by means of a new quantum step which has been additionally set between two adjacent quantum steps in the A/D converter 16. Therefore, the signal represented by the curver III of Fig. 4D, namely, the signal obtained by passing the output signal of curve II of Fig. 4D through the low pass filter 22, is equivalent to a signal which will be obtained when the A/D converter 16 operates in accordance with a quantization characteristic having an additional quantum step beween original quantum steps which have been set in the A/D converter 16. This means that the device according to the present invention provides an improvement by one bit in the resolving power with respect to a low frequency, low level signal, and thus quantization distortion can be reduced according to the present invention compared to the conventional device.

Since the auxiliary signal Pa is synchronized with the sampling signal Ps, no aliasing noise occurs, producing a constant level d.c. component even though the auxiliary signal Pa includes harmonic components. Accordingly, S/N would not be deteriorated even though the amplitude of the auxiliary signal Pa is selected such that the value of "n" in $\frac{2n+1}{2}QS$ is made equal to or greater than 1. Consequently, by setting the value of "n" as $n \geq 1$, improvement in linearity of the A/D converter 16 can be achieved because of the averaging operation of the quantum steps without deterorating S/N of the objective signal.

In addition to the above-mentioned auxiliary
signal Pa, if a conventionally practiced dither signal
(noise signal) is also superposed, reduction of
quantization distortion can be further satisfactorily
performed, and in this case, the level of the noise
signal is required to be only one-half the level of
the conventional one, and thus deterioration of S/N
can be reduced accordingly.

Hence reference is now made to Fig. 6 which
illustrates a second embodiment of the present invention.
The second embodiment differs from the first embodiment
of Fig. 3 in that a dither signal generator 34 for producing
the above-mentioned dither signal to be superposed
on the input analog signal, and an additional adder 32
for effecting the superposition are additionally
employed. In detail, the input terminal 10 is connected
to a first input terminal of the adder 32, whose second
input terminal is connected to the output of the dither
signal generator 34. The output terminal of the adder 32
is connected to the input terminal of the low pass filter 12.
With this arrangement, the dither signal is superposed
on the input analog signal prior to applying the analog
signal via the low filter 12 to the adder 26 in which
the analog signal will be added to the auxiliary signal Pa.

In the above, although it has been described in connection with embodiments in which the input analog signal is converted in the A/D converter 16 after the analog signal is sampled and held in the sample-and-hold circuit 14, it is a matter of course that the present invention may be satisfactorily adapted to a case that the arrangement is such that the analog signal is directly applied to the A/D converter 16 to convert the analog signal into a digital signal (in the case that the variation in magnitude of the analog signal within the conversion time of the A/D converter 16 is smaller than a single quantum step, the analog signal has been directly applied to the A/D converter 16 without using a sample-and-hold circuit hitherto). In the above case, the frequency of the sampling signal used in the above-description may be considered to correspond to the frequency of converting operation of the A/D converter 16.

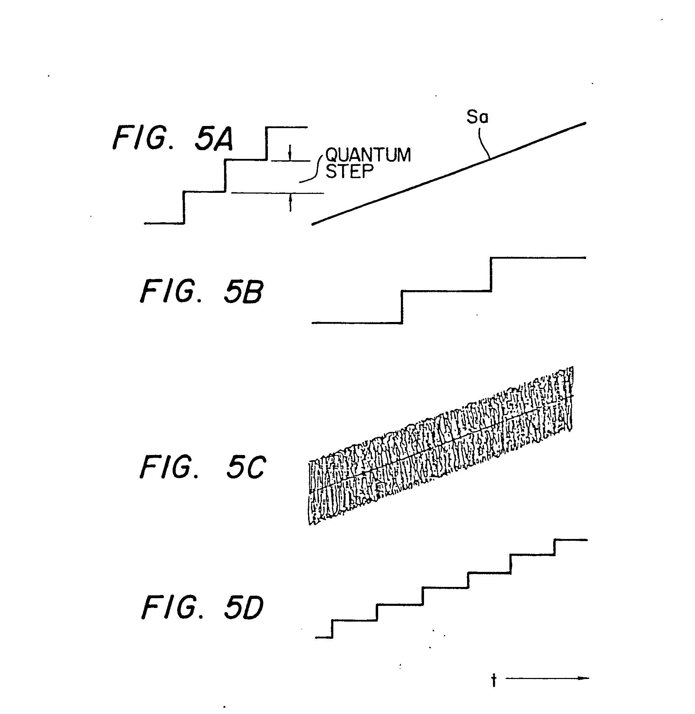

Figs. 5A to D are charts for comparing the input-output characteristics between the conventional device and the device according to the present invention, and Fig. 5A shows the input analog signal Sa, where steps at the left side of the drawing shows the quantization characterisitc; Fig. 5B is a waveform chart of the output signal in the case that quantization distortion reduction is not performed; Fig. 5C is a waveform chart of the output signal in the case that the noise signal is superposed; and Fig. 5D is a waveform chart of the output signal in the device according to the present invention.

As will be apparent from the foregoing description, in the signal processing device according to the present invention, the virtual resolving power has been increased by one bit in the low frequency range, which tends to become a problem particularly, without deteriorating the S/N of the signal. Thus the present invention is capable of readily providing a signal processing device which is simple in construction and has satisfactory characteristics, and therefore, conventional problems can be satisfactorily resolved.

The above described embodiments are just examples of the present invention, and therefore, it will be apparent for those skilled in the art that many modifications and variations may be made without departing from the spirit of the present invention.

CLAIMS

1.      A circuit arrangement for reducing quantization distortion in a signal processing device having a portion in which an input analog signal is converted into digital data at a given conversion frequency, said circuit arrangement comprising:

(a) a first means for generating an auxiliary signal having a frequency which equals one-half said conversion frequency; and

(b) a second means for superposing said auxiliary signal on said input analog signal prior to converting said input analog signal into digital data.

2.      A circuit arrangement as claimed in Claim 1, wherein said portion, in which said analog signal is converted into digital data, comprises a sample-and-hold circuit for sampling and holding the output signal of said second means at a given sampling frequency which corresponds to said given conversion frequency.

3.      A circuit arrangement as claimed in Claim 1, wherein said portion, in which said analog signal is converted into digital data, comprises an analog-to-digital converter for converting the output signal of said second means at said given conversion frequency.

4.      A circuit arrangement as claimed in Claim 2, wherein said first means comprises a divide-by-two frequency divider responsive to said sampling frequency.

5.      A circuit arrangement as claimed in Claim 1, wherein said second means comprises an adder.

6.      A circuit arrangement as claimed in Claim 1, wherein said first means comprises a square wave signal generator.

7.      A circuit arrangement as claimed in Claim 1, wherein said auxiliary signal has an amplitude represented by:

$$\frac{2n + 1}{2} QS$$

wherein "n" is 0, 1, 2, 3 ..... and QS is the quantum step in quantization.

8.      A circuit arrangement as claimed in Claim 7, wherein $n \geq 1$.

9.      A circuit arrangement as claimed in Claim 1, further comprising a low pass filter for filtering said input analog signal prior to applying the same to said second means.

10.    A circuit arrangemet as claimed in Claim 9, further comprising a dither signal generator and means for adding the ditehr signal from said dither signal generator to said input analog signal prior to applying the same to said low pass filter.

11.    A method for reducing quantization distortion in a signal processing device having a portion in which an input analog signal is converted into digital data at a given conversion frequency, said method comprising the steps of:

(a) generating an auxiliary signal having a frequency which equals one-half said conversion frequency; and

(b) superposing said auxiliary signal on said input analog signal prior to converting said input analog signal into digital data.

12.    A method as claimed in Claim 11, further comprising the steps of:

(a) generating a dither signal; and

(b) superposing said dither signal on said input analog signal prior to superposing said auxiliary signal thereon.

## FIG. 1
## PRIOR ART

10 → 12 LPF → 14 SAMPLE HOLD → 16 A/D → 18 RECORDING MEDIUM → 20 D/A → 22 LPF → 24

## FIG. 2
## PRIOR ART

10 → 12 LPF → + 26 Σ + → 14 SAMPLE HOLD → 16 A/D → TO 18

28 NOISE GEN

## FIG. 3

10 → 12 LPF → Sa → + 26 Σ + Pa(fs/2) → 14 SAMPLE HOLD → 16 A/D → TO 18

Ps(fs)

30 AUX SIG GEN

## FIG. 6

10 → + 32 Σ + → 12 LPF → + 26 Σ + Pa(fs/2) → 14 SAMPLE HOLD → 16 A/D → TO 18

34 DITHER SIG GEN

Ps(fs)

30 AUX SIG GEN

FIG. 4A

QUANTUM
STEP

Pa

Sa

FIG. 4B

Pa

FIG. 4C

Ps

FIG. 4D

I

II

III

II

Z

Z

Z

Z

t

FIG. 5A

QUANTUM STEP

Sa

FIG. 5B

FIG. 5C

FIG. 5D

t ⟶

0037259

European Patent Office

**EUROPEAN SEARCH REPORT**

Application number

EP 81 30 1312

| Category | Citation of document with indication, where appropriate, of relevant passages | Relevant to claim |
|---|---|---|
| X | US - A - 2 669 608 (GOODALL)<br><br>* column 1, lines 40-53; column 2, lines 31-54; column 3, line 54 to column 4, line 3; lines 70-73; column 5, line 74 to column 6, line 22 *<br><br>-- | 1-3,6, 10-12 |
| | GB - A - 2 013 053 (ROLM)<br><br>* page 1, lines 10-13; page 4, lines 26-58; lines 76-92 *<br><br>----- | 2,3,9, 10 |

**DOCUMENTS CONSIDERED TO BE RELEVANT**

**CLASSIFICATION OF THE APPLICATION** (Int. Cl.3)

H 04 B 12/02
H 03 K 13/02

**TECHNICAL FIELDS SEARCHED** (Int. Cl.3)

H 04 B 12/02

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 02-07-1981 | HOLPER |

EPO Form 1503.1 06.78